# EUROPÄISCHE PATENTANMELDUNG

(11) **EP 0 525 587 A1**
(43) Veröffentlichungstag der Anmeldung: **03.02.1993**
(21) Anmeldenummer: 92112439.2
(22) Anmeldetag: 21.07.1992
(51) Int. Cl.: H01L 29/06, H01L 29/784, H01L 29/72, H01L 29/08, H01L 23/482

(54) **Durch Feldeffekt steuerbares Halbleiterbauelement**

(30) Priorität: 29.07.1991 DE 4125074
(71) Anmelder: SIEMENS AKTIENGESELLSCHAFT, D-80333 München (DE)
(72) Erfinder: Tihanyi, Jenö, Dr. Ing., W-8000 München 21 (DE)

(57) **Zusammenfassung**

Der Durchlaßwiderstand von MOSFET und IGBT hängt u. a. von der Dicke des Halbleiterkörpers ab. Einer Verringerung der Dicke sind aus mechanischen Gründen Grenzen gesetzt. Die anodenseitige Hauptfläche (3) ist daher mit Vertiefungen (6) versehen; die Dicke des Halbleiterkörpers bleibt partiell erhalten. Die Anodenzone (10) grenzt an die anodenseitige Hauptfläche (3), die Wände (8) und die Böden (7) der Vertiefungen. Damit läßt sich eine Verringerung des Durchlaßwiderstandes und bei IGBT zusätzlich eine Verminderung der Speicherladung erzielen.

## Beschreibung

Die Erfindung bezieht sich auf ein Halbleiterbauelement mit isoliertem Gate und Steuerung durch Feldeffekt, mit einem Halbleiterkörper mit einer ersten Hauptfläche, an die die Sourcezonen angrenzen und mit einer zweiten Hauptfläche, an die die Anodenzone angrenzt.

Halbleiterbauelemente dieser Art sind als Leistungs-MOSFET und als IGBT (Isolated Gate Bipolar Transistor) bekannt geworden. Bei Leistungs-MOSFET tritt das Problem auf, daß sie insbesondere für höhere Spannungen einen großen Durchlaßwiderstand aufweisen, der auf den unipolaren Leitungsmechanismus zurück-zuführen ist. Eine mögliche Maßnahme wäre die Verringerung der Dicke des Halbleiterkörpers. Dem sind jedoch wegen abnehmender mechanischer Stabilität des Halbleiterkörpers Grenzen gesetzt.

Ziel der Erfindung ist es, ein Halbleiterbauelement der erwähnten Gattung so weiterzubilden, daß der Einschaltwiderstand herabgesetzt wird und die mechanische Stabilität erhalten bleibt.

Dieses Ziel wird dadurch erreicht, daß der Halbleiterkörper an der zweiten Hauptfläche mit sich zum Inneren des Halbleiterkörpers verjüngenden Vertiefungen versehen ist und daß die Anodenzone an die zweite Hauptfläche, die Wände und den Boden der Vertiefungen angrenzt.

Weiterbildungen der Erfindung sind Gegenstand der Unteransprüche.

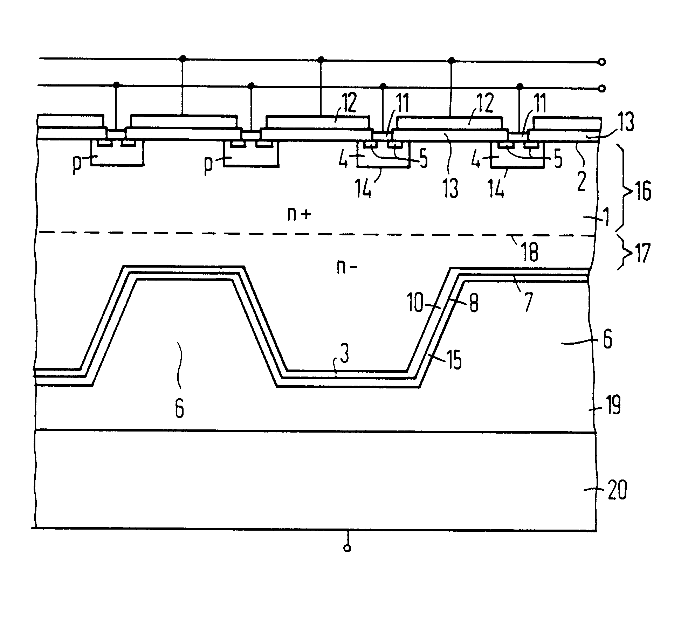

Die Erfindung wird anhand eines Ausführungsbeispiels in Verbindung mit der Figur erläutert. Die Figur stellt einen teilweisen Querschnitt durch einen Halbleiterkörper gemäß der Erfindung dar.

Der Halbleiterkörper hat eine schwach n-dotierte Zone 1. Die obere, sourceseitige Hauptfläche des Halbleiterkörpers ist mit 2, die untere, anodenseitige Hauptfläche ist mit 3 bezeichnet. In das Substrat 1 sind auf der Seite der Hauptfläche 2 p-dotierte Basiszonen 4 eingebettet. In diesen Basiszonen sind stark n-dotierte Sourcezonen 5 eingebettet.

Die anodenseitige Hauptfläche 3 ist mit sich zum Inneren des Halbleiterkörpers verjüngenden Vertiefungen 6 versehen. An die anodenseitige Hauptfläche 3, an die Wände 8 und die Böden 7 der Vertiefung 6 grenzt eine Anodenzone 10. Im Falle eines Leistungs-MOSFET ist diese Zone stark n-dotiert, im Falle eines IGBT stark p-dotiert. Die Anodenzone 10 ist mit einer Metallschicht 15 versehen.

Die Sourcezonen 5 und die Basiszonen 4 sind von Sourceelektroden 11 kontaktiert. Im übrigen ist die Hauptfläche 2 von einer Isolierschicht 13 bedeckt. Auf der Isolierschicht 13 sitzen Gateelektroden 12, die die Basiszonen 4 dort, wo sie an die Hauptfläche 2 angrenzen, überdecken und die die Sourcezonen teilweise überlappen. Zwischen den Basiszonen 4 und dem Substrat 1 liegen pn-Übergänge 14.

Die Vertiefungen 6 können eine Tiefe zwischen 50 und 500 um haben je nach Dicke des Halbleiterkörpers. Die Tiefe der Vertiefungen 6 muß so gewählt werden, daß sich eine von den pn-Übergängen 14 ausgehende Raumladungszone 16 bei der höchsten Sperrspannung nicht bis zur Grenze 18 der Raumladungszone 16 ausbreitet. Sicherheitshalber liegt zwischen den Böden 7 der Vertiefung 6 und der Grenze 18 der Raumladungszone 16 ein Abstand 17 von 10 bis 100 um.

Dadurch, daß die Dicke des Halbleiterkörpers partiell vermindert ist, wird der Durchlaßwiderstand des Halbleiterbauelements abgesenkt. Bei einem IGBT kommt noch der Vorteil dazu, daß damit die Trägerspeicherladung, die eine Funktion der Dicke des Halbleiterkörpers ist, verringert wird. Damit läßt sich der sogenannte "Tail-Strom" verkleinern.

Die Vertiefungen 6 können mit Lot oder leitfähigem Kleber gefüllt werden. Damit läßt sich der Halbleiterkörper mit einer Bodenplatte oder einem Kühlkörper 20 thermisch und elektrisch leitend verbinden. Der Kühlkörper bzw. die Metallplatte 20 bildet dann die Anodenelektrode des Halbleiterbauelements. Die Vertiefungen lassen sich durch bekannte Verfahren wie Plasmaätzen, Ätzen oder Funkenerosion erzeugen.

## Patentansprüche

1. Halbleiterbauelement mit isoliertem Gate und Steuerung durch Feldeffekt, mit einem Halbleiterkörper mit einer ersten Hauptfläche, an die die Sourcezonen angrenzen und mit einer zweiten Hauptfläche, an die die Anodenzone angrenzt,
dadurch gekennzeichnet, daß der Halbleiterkörper an der zweiten Hauptfläche (3) mit sich zum Inneren des Halbleiterkörpers verjüngenden Vertiefungen (6) versehen ist und daß die Anodenzone (10) an die zweite Hauptfläche (3), die Wände (8) und die Böden (7) der Vertiefungen angrenzt.

2. Halbleiterbauelement nach Anspruch 1, dadurch gekennzeichnet, daß die Anodenzone (10) mit einer Metallschicht (15) bedeckt ist.

3. Halbleiterbauelement nach Anspruch 2, dadurch gekennzeichnet, daß die Vertiefungen (6) mit Lotmetall ausgefüllt sind.

4. Halbleiterbauelement nach Anspruch 2, dadurch gekennzeichnet, daß die Vertiefungen (6) mit leitfähigem Kleber ausgefüllt sind.

5. Halbleiterbauelement nach einem der Ansprüche 1 bis 4, dadurch gekennzeichnet, daß die Anodenzone (10) den gleichen Leitungstyp wie die Sourcezonen (5) hat.

6. Halbleiterbauelement nach einem der Ansprüche 1 bis 4,
dadurch gekennzeichnet, daß die Anodenzone (10) den entgegengesetzten Leitungstyp wie die Sourcezonen (5) hat.
